# FASCICULE DE BREVET EUROPEEN

(11) **EP 1 198 295 B1**
(45) Date de publication et mention de la délivrance du brevet: **03.09.2003**
(21) Numéro de dépôt: 00953265.6
(22) Date de dépôt: 19.07.2000
(51) Int. Cl.: B01L 3/00, H01L 21/58, B01J 19/00

(54) **DISPOSITIF D'ANALYSE AVEC UNE BIOPUCE**
ANALYSEVORRICHTUNG MIT EINEM BIOCHIP
ANALYSING DEVICE WITH BIOCHIP

(30) Priorité: 19.07.1999 FR 9909488
(43) Date de publication de la demande: 24.04.2002
(73) Titulaire: BIO MERIEUX, 69280 Marcy l'Etoile (FR)
(72) Inventeur: GUERITAULT, Thomas, CH-1020 Renens (CH); ODIET, Maxime, CH-2036 Cormondrèche (CH); PRELAZ, Jean-Claude, CH-2025 Chez-Le-Bart (CH)
(74) Mandataire: Guerre, Dominique
(86) Numéro de dépôt international: FR0002079
(87) Numéro de publication internationale: WO01005504

(56) Documents cités:
- EP-A- 0 498 703
- WO-A-90/05910
- WO-A-95/33846
- WO-A-98/01221
- US-A- 5 218 229

## Description

La présente invention concerne un dispositif d'analyse d'au moins un analyte, comprenant un contenant et une biopuce, cette dernière étant fixée au contenant par un moyen de fixation approprié.

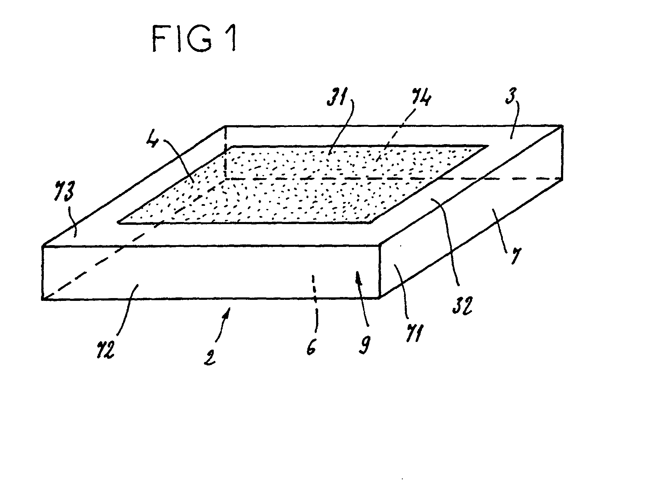

Par "biopuce", et par référence à la Figure 1, on entend tout composant comprenant, de manière connue en soi, un support 9, notamment de forme polyédrique, par exemple parallélépipédique. Ce support 9 comporte, premièrement une face active 3 comprenant une surface active 31 sur laquelle sont distribués et attachés une multiplicité de ligands 4 mis en jeu pour l'analyse, et, éventuellement, selon le procédé de détection mis en oeuvre, une zone périphérique 32 exempte de ligands, deuxièmement au moins une face opposée 6 à la face active, par exemple parallèle à la face active, et une bande transversale 7 et périphérique, ou tranche, reliant les faces active 3 et opposée 6, comportant par exemple plusieurs chants 71 à 74 dans le cas d'une forme parallélépipédique.

Avantageusement, la surface de la surface active est inférieure à 100 mm², par exemple inférieure à 65 mm², et préférentiellement inférieure à 30 mm². L'épaisseur du support, par exemple largeur de la bande transversale 7, est inférieure à 5 mm, avantageusement à 1 mm. Dans certains cas, le support de la biopuce a la forme d'une galette cylindrique, auquel cas la bande transversale ne comporte aucune arête.

Préférentiellement, la surface active représente au moins 75 % de la surface de la face active.

Les ligands peuvent être fixés de différentes manières, notamment par adsorption ou covalence comme par exemple la synthèse in situ par les techniques de photolithographie ou par un système piézo-électrique, par dépôt capillaire de ligands préformés. A titre d'illustration, des exemples de ces biopuces sont donnés dans les publications de G. Ramsay, Nature Biotechnology, 16, p40-44, 1998; F. Ginot, Human Mutation, 10, p1-10, 1997 ; J. Cheng et al, Molecular diagnosis, 1(3), p183-200, 1996 ; T. Livache et al, Nucleic Acids Research, 22(15), p2915-2921, 1994 ; J. Cheng et al, Nature Biotechnology, 16, p541-546, 1998, ou dans les brevets US 4981783 (Augenlicht), US 5700637 (Southern), US 5445934 (Fodor), US 5744305 (Fodor), US 5807522 (Brown).

L'état de la technique est constitué par le document WO95/33846, qui décrit un consommable pour l'analyse biologique, dans lequel une biopuce est fixée sur un support plastique. Cette biopuce de forme parallélépipèdique comprend sur sa face active un grand nombre, généralement plusieurs milliers jusqu'à plusieurs centaines de milliers, d'oligonucléotides positionnés à des endroits prédéterminés. Plusieurs moyens de fixation de la biopuce sont décrits, aussi bien par collage que par scellage. Mais dans tous les cas une partie de la face active de la biopuce, où se trouvent les oligonucléotides, est utilisée pour la fixation sur le plastique. Dans ce cas, la place affectée sur la face active à la fixation de la biopuce sur le consommable n'est pas disponible pour y greffer des oligonucléotides.

Deux contraintes se posent pour l'application industrielle de ces biopuces. D'une part, la volonté de réduire les coûts de production de ces biopuces implique une réduction de la taille de ces dernières, avec comme conséquence indirecte une réduction de la taille du consommable, ce qui diminue d'autant les coûts du dispositif. D'autre part, le souhait de réaliser avec une même biopuce plusieurs analyses simultanées (comme la détection d'un panel d'agents pathogènes dans un échantillon biologique, ou la détection de l'effet d'une molécule sur l'expression d'une multitude d'ARN messagers pour identifier la voie métabolique sur laquelle agit cette molécule) conduit à une augmentation du nombre de ligands sur la surface de la biopuce. Ainsi, la logique industrielle conduit à mettre un maximum de ligands sur un minimum de surface.

La technique décrite dans la demande WO95/33846 présente donc l'inconvénient majeur d'utiliser une partie de la face active de la biopuce pour sa fixation sur un consommable, ce qui n'est pas compatible avec les contraintes industrielles décrites ci-dessus.

En outre, il est important que la détection optique ne soit pas affectée par le moyen de fixation.

La présente invention résout le problème ainsi posé, en proposant un dispositif selon les revendications 1 et 2. De maniere générale un moyen de fixation unique de la biopuce relie, d'un côté la bande transversale ou tranche du support de ladite biopuce, pratiquement à l'exclusion de toute autre partie, face, ou surface de la dite biopuce, et de l'autre côté, le contenant, et ce de part et d'autre de la face active de la biopuce ; et ce moyen de fixation découvre par ailleurs la totalité de la zone périphérique de la face active de la biopuce, c'est à dire qu'il n'obstrue ni ne masque, au moins en partie ladite face active.

Par "pratiquement", on entend que le moyen de fixation découvre au moins 95 % de la totalité de la face active, avantageusement au moins 97 %, et préférentiellement au moins 99 %.

Selon la présente invention, deux cas de figure doivent être envisagés, selon que, en fonction du procédé de détection des ligands, la surface active se confond avec la surface complète de la face active, ou qu'une zone périphérique, exempte de ligands, entoure la surface active, et s'étend en largeur entre ladite surface active et le bord de la face active.

Dans le premier cas, le moyen de fixation découvre pratiquement en totalité, sinon complètement la surface active.

Dans le second cas, le moyen de fixation découvre également, en totalité, la zone périphérique de la face active.

Un certain nombre de termes utilisés dans la présente invention est explicité ci-dessous.

Par "dispositif d'analyse", on entend tout appareil permettant l'analyse d'un ou plusieurs échantillons liquides ou gazeux différents, dans lequel on cherche à identifier et/ou quantifier un ou plusieurs analytes selon tous processus simples ou complexes d'analyse, mettant en jeu un ou plusieurs réactifs différents selon la nature chimique, physique ou biologique du ou des analytes recherchés. Les principes techniques définis ci-après ne sont pas limités à un analyte particulier, la seule condition requise étant que l'analyte soit distribué dans l'échantillon à analyser, en suspension ou en solution. En particulier, le processus d'analyse mis en oeuvre peut être effectué, sous forme homogène ou hétérogène ou mixte. Un exemple d'application des techniques d'analyse concerne les immunoessais, quelque soit leur format, par analyse directe ou par compétition. Un autre exemple d'application concerne la détection et/ou la quantification d'acides nucléiques, comprenant l'ensemble des opérations nécessaires à cette détection et/ou cette quantification à partir d'un prélèvement quelconque contenant les acides nucléiques cibles. Parmi ces différentes opérations, on peut citer la lyse, la fluidification, la concentration, les étapes d'amplification enzymatique des acides nucléiques, les étapes de détection incorporant une étape d'hybridation. La demande de brevet WO 97/02357, dont le contenu de la description est incorporé dans la présente demande explicitent différentes étapes nécessaires dans le cas d'analyse d'acides nucléiques.

Par "ligand" on entend toute espèce biologique ou chimique susceptible de réagir spécifiquement avec un récepteur présent sur l'analyte. A titre d'exemple de ligand on peut citer un antigène, un fragment d'antigène, un peptide , un anticorps, un fragment d'anticorps, un haptène, un acide nucléique, un fragment d'acide nucléique, un polynucléotide, une hormone, une vitamine, un sucre, un polysaccharide , un chélateur, une drogue, un cofacteur, une molécule chimique capable de se lier par covalence ou par adsorption. Avantageusement les ligands fixés sur la biopuce sont des acides nucléiques et préférentiellement des oligonucléotides, et sont fixés sur la biopuce par couplage covalent. Dans un mode préférentiel de réalisation, au moins 400 séquences différentes d'oligonucléotides et préférentiellement au moins 1000 sont fixées par cm2 du support solide de la biopuce.

Le support solide doit être adapté à la fixation des ligands. Des matériaux naturels ou de synthèse, modifiés ou non chimiquement, peuvent être utilisés comme support solide, notamment des polymères tels que polychlorures de vinyle, polyéthylènes, polystyrènes, polyacrylates, polyamides, ou des copolymères à base de monomères du type styrène, esters d'acides carboxyliques insaturés, chlorure de vinylidène, diènes ou composés présentant des fonctions nitrile (comme l'acrylonitrile) ; des matériaux inorganiques tels que la silice, le quartz, des verres, des céramiques ; des dérivés métalliques. En particulier, le support solide est réalisé en matériau non poreux. Dans un mode particulier de réalisation, le support solide est réalisé dans un matériau transparent à la lumière et notamment le verre ou dérivés.

Le «contenant» est défini comme la pièce ou l'ensemble de pièces permettant de mettre en oeuvre l'analyse, et sur lequel est fixé la biopuce, le contenant et ladite biopuce délimitant ensemble au moins un compartiment réactionnel. Notamment, ce contenant permet l'introduction d'un fluide et notamment du liquide dans lequel se trouvent le ou les analytes à analyser, et de délimiter au moins un compartiment réactionnel pour favoriser la réaction entre les ligands et le ou les analytes.

Selon une variante de l'invention, le moyen de fixation assure l'étanchéité du compartiment réactionnel, par rapport à l'extérieur.

Préférentiellement, la surface active est tournée vers l'intérieur du contenant pour permettre le contact entre le milieu liquide dont on veut analyser le contenu, et les ligands fixés sur cette surface active, et la face opposée est tournée vers l'extérieur du contenant.

A titre d'exemple, ce contenant est un consommable à usage unique tel que décrit dans les demandes de brevet WO 95/33846, WO 97/02357, WO 97/27324. Mais il peut aussi être réutilisé. Le contenu de la description de ces demandes de brevet précitées est considéré comme incorporé dans la description de la présente invention. Dans un mode préférentiel de réalisation selon l'invention, le contenant est dans un matériau plastique tel que le polypropylène ou le polystyrène et il est obtenu par moulage. Selon une variante de l'invention, un traitement de surface pourra être réalisé sur le contenant, notamment si le contenant est réalisé en polyoléfine, et en particulier si le contenant est réalisé en polypropylène pour augmenter l'adhérence de l'adhésif sur le contenant. Ce traitement de surface peut être un traitement Corona, un flammage, un nettoyage des surfaces comme un dégraissage, une attaque chimique de surface.

Pour fixer la biopuce sur un contenant, il est nécessaire de prévoir sur le contenant une partie susceptible de recevoir la biopuce. Cette zone de réception est définie comme étant la fenêtre du contenant. En particulier, cette fenêtre a un profil transversal sensiblement identique à celui du support de la biopuce, avec une dimension légèrement plus importante. Par légèrement plus importante, on entend un interstice entre la bande transversale de la biopuce et la bordure de la fenêtre du contenant, compris entre 2 mm et 0,05 mm, avantageusement compris entre 0,5 mm et 0,05 mm et préférentiellement compris entre 0,2 mm et 0,1 mm.

Cet interstice a en particulier une valeur régulière le long de la bordure transversale du support de la biopuce, relativement faible, soit pour permettre la rétention par capillarité de l'adhésif à l'état liquide, aussi longtemps que ce dernier n'est pas polymérisé, soit pour éviter l'écoulement de la colle si celle-ci est suffisamment visqueuse.

Par "fixation", on entend toute solution ou moyen permettant toute liaison permanente entre la biopuce et le contenant, respectant la définition précitée. A titre d'exemple, on peut citer la soudure par laser, la soudure par ultrasons, la soudure par microplasmas, la soudure par induction, la soudure à haute fréquence, la soudure anodique, le collage, l'adhérence moléculaire, le sertissage à chaud, le blocage mécanique par clipsage, serrage par un système de butée, par liaison souple c'est à dire déformable comme avec un joint caoutchouc.

Avantageusement, la fixation est réalisée par collage, comme par exemple avec des adhésifs multicomposants tels que une colle dentaire, une colle à base de polymère dissous dans un solvant (polystyrène dissous dans le xylène par exemple), des colles polyuréthanne, des colles époxy, des colles instantanées comme les colles cyanoacrylates, les colles UV c'est à dire les colles qui polymérisent sous l'action d'un rayonnement ultraviolet. Des colles de ce type sont vendues par la société DYMAX (Torrington CT, USA) sous la référence 128-M ou la référence 1-20-270 ou 1-20-280, ou par la société EPOTECNY (Vélizy, France) sous la référence NOA 63, NOA 68, NOA 72, NEA 121 ou par la société LOCTITE (Dublin, Irlande) sous la référence 3011, 3301, 3311, 3104 ou 3105. Préférentiellement, la fixation est réalisée avec un adhésif polymérisable par rayonnement ultraviolet, comme la colle Dymax 1-20-280.

Dans un mode particulier de réalisation de l'invention, le moyen de fixation s'étend selon la totalité de la bande transversale de la biopuce. Selon une variante de l'invention, et notamment dans le cas où le support de la biopuce est un parallélépipède à base rectangulaire ou carrée, et où la fixation s'effectue par collage, le joint d'adhésif recouvre les quatre chants et les quatre angles droits. Dans un mode préférentiel de réalisation de l'invention où la fixation s'effectue par collage, le contenant présente une structure particulière au niveau de la zone de liaison entre la bande transversale de la biopuce et la fenêtre du contenant, comme par exemple une forme en biseau pour permettre à un éventuel excès d'adhésif de se positionner sur la partie du contenant. Un méplat peut aussi être présent sur le contenant pour éliminer cet éventuel excès d'adhésif, comme cela sera explicité sur les figures. Ce moyen permet le stockage d'un surplus d'adhésif sans débordement sur la zone périphérique de la biopuce.

Toujours dans ce mode de réalisation par collage, et dans le but d'améliorer la résistance mécanique du joint d'adhésif, une concavité peut être ménagée sur tout ou partie du pourtour de la fenêtre du contenant, comme par exemple une rainure ou un canal. L'adhésif en polymérisant à l'intérieur d'au moins une partie de la concavité améliore la fixation entre le contenant et la biopuce.

Dans un autre mode particulier de réalisation de l'invention, le moyen de fixation relie deux zones opposées de la bande transversale de la biopuce. Dans ce cas, le long de la bande transversale, le moyen de fixation est discontinu entre la biopuce et le contenant.

Selon une autre variante, le moyen de fixation relie quatre zones de la bande transversale de la biopuce, les quatre zones étant réparties de manière sensiblement symétrique pour augmenter la rigidité et donc la tenue mécanique du dispositif d'analyse.

Selon une autre variante de l'invention, le moyen de fixation comprend des moyens flexibles au niveau de la fenêtre du contenant, et exercent une pression sur la bande transversale de la biopuce pour faciliter le positionnement de ladite biopuce. Par exemple, une fenêtre avec une géométrie particulière est réalisée sur le contenant lors de son injection avec une matière plastique. Ces moyens flexibles sont conçus pour recevoir la biopuce et la maintenir en place. Ces moyens doivent être suffisamment souples pour permettre l'insertion de la biopuce, avec une force modérée, mais suffisamment rigides pour permettre une bonne répétabilité d'insertion sans pour autant être cassants.

Ces moyens ont pour fonction de fixer la biopuce ou de la maintenir en place, avant de réaliser la fixation définitive. A titre d'exemple, ces moyens maintiennent la biopuce en place, grâce à la pression exercée sur les quatre chants de la biopuce de forme parallélépipédique de base carrée, le temps de placer un cordon de colle de type UV. Une fois la polymérisation effectuée, la fixation de la biopuce sur le contenant est achevée.

Selon une variante de l'invention, les moyens flexibles sont constitués de deux parties solidaires entre elles, à savoir une première partie ou intermédiaire, inclinée par rapport à la face opposée de la biopuce et une deuxième partie ou terminale, perpendiculaire à ladite face opposée et qui vient presser la bande transversale de la biopuce.

Selon une autre variante de l'invention, les moyens flexibles comprennent des griffes de section sensiblement triangulaire. Ces griffes exercent une pression sur la bande transversale ou tranche de la biopuce.

Selon une variante de l'invention, le support de la biopuce est constitué d'une matière transparente à la lumière, comme par exemple le verre ou les dérivés du verre. Cette variante est particulièrement intéressante pour une lecture optique de la réaction d'analyse, comme par exemple une lecture de fluorescence à travers le verre.

Avec la solution de fixation de la présente invention, la surface active de la biopuce où sont fixés les ligands peut débuter au plus proche de la bordure du support. La paroi du contenant peut bloquer une partie de la lumière émise lors de la révélation. Cette limitation a deux conséquences : réduire localement la résolution spatiale de la biopuce et réduire localement l'intensité collectée, donc réduire localement la sensibilité de la dynamique de détection. Il existe donc une marge m à respecter, appartenant à la zone périphérique 32, qui est la distance entre le bord du biopuce et la surface active où sont greffés les ligands. Le calcul de cette marge est relié à l'ouverture numérique de l'optique, à l'épaisseur et à l'indice du verre de la biopuce. Si on désigne par ON l'ouverture numérique de l'optique, par n l'indice de réfraction du verre, et par e l'épaisseur du verre, la marge optique m est égale à e.tg [arcsin (ON/n)]. A titre d'exemple, pour une épaisseur de verre de 0,7 mm et un indice de 1,46, la marge m varie entre 255 et 548 µm, pour des optiques dont l'ouverture numérique est comprise entre 0,5 et 9.

Dans le cas le plus défavorable, pour une biopuce dont la face active est carrée et de surface 25 mm2, la surface de la zone périphérique 31 peut être réduite jusqu'à 9,9 % de la surface de la face active 3 ; alors qu'antérieurement à l'invention, avec un moyen de fixation traditionnel, cette même surface peut représenter jusqu'à 80 % de la surface de la face active 3.

Les ligands 4 peuvent être répartis sur au moins 75 % de la surface de la face active de la biopuce, et avantageusement à des positions prédéterminées. Il est clair que cette marge, dans le cas de la présente invention, est minime, car le moyen de fixation selon la présente invention découvre pratiquement la totalité de la zone périphérique, et sur la face active et sur la face opposée.

L'invention concerne également un procédé de fixation d'une biopuce à un contenant, pour réaliser un dispositif d'analyse, caractérisé par le fait que l'on maintient la biopuce en regard du contenant, que l'on répartit un joint d'adhésif liquide entre la bande transversale de la biopuce et le contenant, et que l'on polymérise l'adhésif par rayonnement ultraviolet.

Dans un mode de réalisation particulier de l'invention, on dispose la biopuce par rapport au contenant, pour mettre en regard la bande transversale de la biopuce et l'encadrement de la fenêtre du contenant, et permettre la fixation.

Avantageusement, l'on dispose de deux moyens de positionnement, un pour la biopuce et un pour le contenant.

Ces moyens de positionnement peuvent être constitués par un bloc, par exemple métallique sur lequel repose le contenant. Dans un mode de réalisation particulier de l'invention, un moyen pour maintenir le contenant et/ou la biopuce en place consiste à appliquer une dépression à l'aide d'au moins un orifice placé sur le bloc. Un moyen de positionnement de la biopuce peut être constitué par un support, par exemple cylindrique, sur lequel repose la biopuce et ayant au moins un orifice débouchant sur la surface en contact avec la biopuce, pour appliquer une dépression pour le maintien de cette dernière. Les mouvements de ces moyens de positionnement peuvent être contrôlés par un robot selon les 3 axes x,y,z. Une précision de positionnement de l'ordre de ± 0,2 mm peut être facilement atteinte, dans la mesure où les références de positionnement sont repérables en mode automatique, soit par vision artificielle, soit mécaniquement. Dans le cas d'une lecture optique, comme par exemple, une lecture par fluorescence avec une caméra CCD ou un laser, la planéité de la surface active est importante, comme par exemple, avec une tolérance de 50 micromètres sur la diagonale pour ne pas fausser la mise au point du système optique. La présente invention résout ce problème, notamment dans le cas de la fixation par un joint d'adhésif, puisque ledit joint permet de compenser ou absorber les imperfections sur la surface, aussi bien sur la bande transversale ou tranche de la biopuce que sur l'encadrement de la fenêtre du contenant. Dans un mode de réalisation où le support de la biopuce est en verre ou dérivé, et où ladite biopuce est obtenue à partir d'une plaque qui est découpée comme décrit dans le brevet WO95/33846, ou par d'autres techniques comme la scie diamantée, le jet d'eau ou le découpage laser, le mode de fixation par dépose d'un joint de colle entre la biopuce et la fenêtre du contenant est particulièrement adapté. De la même manière, cette technique permet de diminuer les contraintes d'état de surface sur le moule, dans le cas où le contenant est obtenu par moulage d'une matière plastique technique.

Le rayonnement ultraviolet est appliqué au niveau du joint d'adhésif, en illuminant au moins une des faces du dispositif d'analyse. Dans un premier mode de réalisation, dans le cas où le contenant est en une partie, comme par exemple un consommable de type carte tel que décrit dans la demande de brevet de la Demanderesse FR 2 749 663, une fenêtre est prévue sur le contenant pour la mise en place de la biopuce. Après mise en place de la biopuce en regard de la fenêtre du contenant, dépose du joint de colle, la polymérisation est effectuée en une étape de 10 à 40 secondes.

Dans un deuxième mode de réalisation, où le contenant est en deux parties, la polymérisation du joint de colle est effectuée en deux étapes. Après mise en place du contenant et de la biopuce par les moyens de positionnement, une première étape consiste à prépolymériser le point de colle par irradiation UV pendant un temps court, compris entre 2 et 30 secondes, et avantageusement compris entre 5 et 15 secondes. Dans une deuxième étape, la colle est polymérisée par irradiation UV de l'autre coté, dans un temps compris entre 5 et 40 secondes, et avantageusement entre 15 et 30 secondes. Ces temps varient en fonction de la nature de la colle et de la puissance de la lampe d'irradiation et sont déterminés par l'homme du métier. Un temps court de polymérisation doit être recherché pour augmenter la cadence du procédé de fabrication.

Pour protéger les ligands sur la face active, contre l'effet du rayonnement ultraviolet qui peut dégrader des molécules biologiques ou chimiques, on positionne un cache entre la biopuce et le rayonnement ultraviolet. Dans une variante de l'invention, le moyen de positionnement de la biopuce fait office de cache. Dans un autre variante de l'invention, un doigt réglable en hauteur permet de protéger la face active de la biopuce.

Les figures et exemples ci-dessous sont donnés à titre d'exemple explicatif et n'ont aucun caractère limitatif. Ils permettront de mieux comprendre l'invention. Pour des raisons de clarté du dessin, les différents éléments des dessins ne sont pas représentés à l'échelle.

Dans le dessin annexé :
- comme dit plus haut, et déjà décrit, la figure 1 représente en perspective et de manière schématique, une biopuce telle que considérée par la présente invention ;
- La figure 2 représente schématiquement une vue partielle en coupe d'un dispositif d'analyse selon un mode de réalisation de la présente invention ;
- la figure 3A représente schématiquement une vue en coupe de la zone de fixation d'une biopuce sur un contenant, selon un mode particulier de réalisation de la présente invention ;

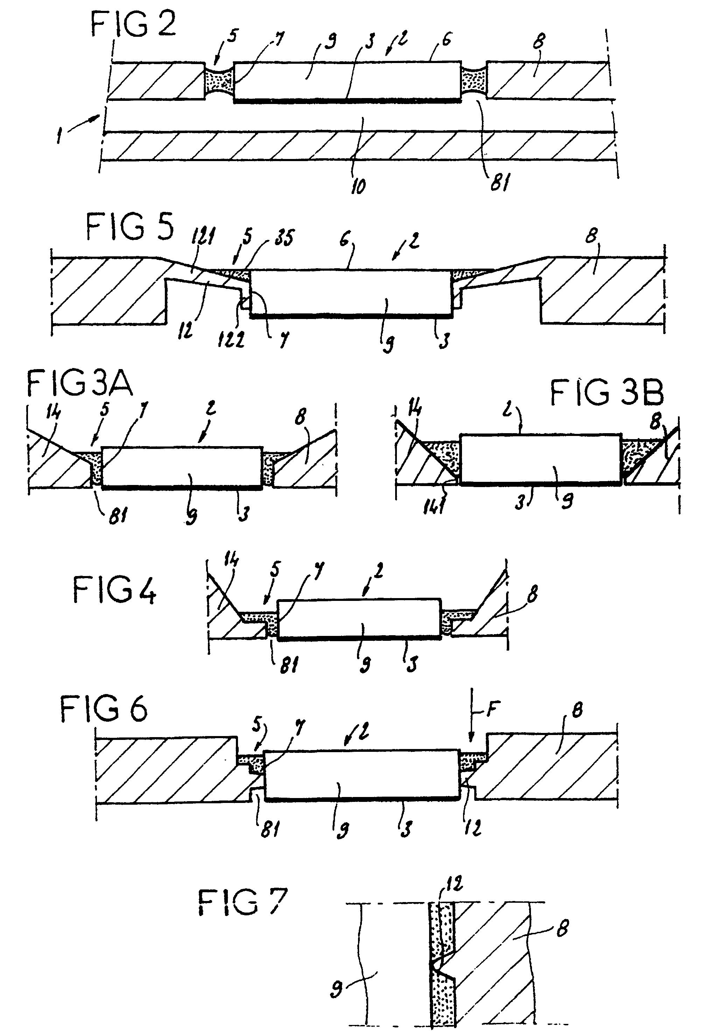

- la figure 3B représente un mode préférentiel de fixation selon l'invention dans lequel un moyen 14 pour éliminer un surplus de colle est représenté. Ce moyen comme dans la figure 3A a une forme biseautée au niveau de la fenêtre 81 du contenant et présente un angle à 45°. D'autres angles peuvent être utilisés. Contrairement à la figure 3A, le méplat 141 à l'extrémité du biseau est d'une hauteur faible par exemple entre 0,05 et 0,1 mm pour une épaisseur de biopuce de 0,7 mm. L'interstice entre la partie périphérique de la biopuce et le méplat 141 est réduit de telle manière que la colle ne puisse pas se glisser dans l'interstice comme représenté sur la figure 3B. La forme biseautée permet en outre de faciliter le positionnement de l'aiguille entre le contenant et la biopuce et de plus permet d'éviter le débordement de la colle sur la face supérieure de la biopuce 2. Le méplat 141 associé à l'interstice et à la viscosité de la colle permet d'éviter l'écoulement de la colle dans l'interstice et donc le débordement de colle sur la face active 3 de la biopuce. Ce moyen de fixation permet donc une lecture optique sur la totalité de la face active avec une surface active aussi grande que possible ;
- la figure 4 représente schématiquement une vue en coupe de la zone de fixation d'une biopuce sur un contenant, selon un autre mode particulier de réalisation de la présente invention ;
- la figure 5 représente une vue en coupe de la zone de fixation d'une biopuce sur un contenant, avec des moyens flexibles en deux parties ;
- la figure 6 représente une vue en coupe de la zone de fixation d'une biopuce sur un contenant, avec des moyens flexibles en forme de griffe ;
- la figure 7 représente une vue selon F du dessus de la griffe représentée à la figure 6 ;
- la figure 8 représente une partie de la fenêtre du contenant, avec un moyen pour le stockage du surplus de colle en forme de rainure ;
- les figures 9 à 11 représentent respectivement une première étape, une deuxième étape et une troisième étape du procédé de fixation de la biopuce sur un contenant, selon un mode particulier de réalisation de la présente invention ;
- la figure 12 représente schématiquement une partie du banc de test pour le collage ;
- la figure 13 représente schématiquement le banc de test pour les essais de résistance mécanique et d'étanchéité.

La figure 2 montre une vue partielle en coupe d'un dispositif d'analyse 1 dans lequel une biopuce 2 est fixée sur un contenant 8, par l'intermédiaire d'un moyen de fixation 5. Ce moyen de fixation, représenté sur la figure 2 par un joint de colle, n'empiète ni sur la face active 3, où sont présents des ligands, ni sur la face opposée 6. Pour ce faire, le joint de colle est présent entre la bande transversale 7 ou tranche de la biopuce, ou plus précisément de son support, et l'encadrement de la fenêtre 81 du contenant 8. Dans ce mode de réalisation, la surface active 31 de la biopuce est tournée vers l'intérieur du contenant, et la face opposée vers l'extérieur. Un liquide, contenant des analytes, et non représenté sur la figure peut ainsi interagir avec les ligands 4 dans le compartiment réactionnel 10. Le joint de colle assure l'étanchéité du compartiment 10 par rapport à l'extérieur, sur cette partie du contenant. Le dispositif d'analyse est représenté de manière schématique, mais il est bien entendu que l'homme du métier pourra faire varier les différents éléments dudit dispositif en fonction de la ou des analyses à effectuer, sans pour autant sortir du cadre de l'invention. Parmi ces éléments non représentés, on peut citer : le système d'introduction et/ou de sortie de l'échantillon ainsi que d'éventuels réactifs nécessaires à l'analyse ; un ensemble de canaux pour orienter le liquide ; des systèmes de vannes qui permettent de contrôler le mouvement de l'échantillon liquide introduit ; des moyens de déplacement de liquide ; des moyens de contrôle de la température ; des zones de stockage de réactifs. De nombreuses descriptions de vannes existent dans l'art antérieur, et en particulier les vannes décrites dans la demande de brevet déposée par la demanderesse en date du 8 Septembre 1998 sous le numéro de dépôt FR-98/11383. Les systèmes de déplacement de fluide comme des systèmes de pompage peuvent être incorporés à l'intérieur ou à l'extérieur du dispositif, comme par exemple des pompes à diaphragme (US 5277556), des pompes péristaltiques piézo-électriques (US 5126022), des systèmes de transport par ferrofluides, des pompes électrohydrodynamiques (Richter et al., Sensors and Actuators, 29, p159-165, 1991)

Bien entendu, un canal ou plusieurs canaux permettent d'amener le liquide dans le compartiment réactionnel 10. Ces canaux associés peuvent être intégrés audit dispositif d'analyse 1, et permettre l'envoi du liquide vers d'autres zones du contenant ou vers d'autres contenants, où d'autres traitements et/ou réactions pourront être opérés. De la même manière, une ou plusieurs biopuces 2 peuvent être fixées sur le même contenant 8 dans le cas d'analyse multiple.

Les figures 3A, 3B et 4 présentent une vue en coupe de la fixation de la biopuce 3 dans la fenêtre 81 du contenant 2, selon un mode particulier et préférentiel de fixation selon l'invention, dans lequel un moyen 14 pour éliminer un éventuel surplus de colle est représenté. Dans les figures 3A et 3B, ce moyen 14 a une forme biseautée au niveau de la fenêtre 81 du contenant. L'angle représenté est de 45°, mais d'autres angles sont utilisables pour peu que la colle puisse remonter le long de cette pente. La figure 4 représente une variante du mode de fixation représenté à la figure 2, dans lequel un méplat est ajouté entre la biopuce et la forme biseautée.

Sur ces schémas, l'encadrement de la fenêtre 81 présente une tranche parallèle à la bande transversale 7 de la biopuce 6. Cette configuration présente deux avantages : amélioration de la résistance mécanique de la fenêtre et augmentation de la surface de contact pour la colle sur le contenant 8, ce qui améliore la fixation.

Les figures 5 à 6 représentent un autre mode de réalisation de la présente invention, par des vues en coupe de la zone de fixation de la biopuce 2 sur le contenant 8, avec l'ajout de moyens flexibles 12 favorisant le maintien de la biopuce. Sur la figure 5, ces moyens flexibles 12 sont en deux parties. Une première partie 121 est inclinée par rapport à la face opposée 6 de la biopuce et une partie terminale 122 sensiblement perpendiculaire à ladite face opposée et donc, dans le cas du schéma, parallèle à la bande transversale 7 de la biopuce. Cette partie terminale vient en appui contre un chant de la biopuce pour faciliter le maintien et ou le positionnement de la biopuce. Sur la figure 5, un moyen de fixation représenté par un joint de colle 35 assure l'étanchéité de la fixation, mais il est possible de maintenir la biopuce par la seule pression des moyens flexibles 12. Pour maintenir la biopuce 2 en place, il est bien entendu que les forces de pression appliquées sur la biopuce par ces moyens 12 s'annulent, et l'homme du métier définira le nombre et le positionnement de ces moyens sur la fenêtre 81 du contenant pour respecter cette contrainte. Dans le cas d'une biopuce de forme parallélépipédique carrée, un ou deux moyens 12 en vis-à-vis des deux cotés respectivement sont adaptés.

L'angle entre la première partie inclinée 121 des moyens flexibles 12 et la face opposée 6 de la biopuce a deux fonctions : permettre d'insérer la biopuce 2 verticalement pour la mettre en regard du contenant 8 sans casser lesdits moyens flexibles, et permettre l'élimination du surplus de colle comme pour la partie biseautée décrite ci-dessus par référence aux figures 3 et 4. Les moyens flexibles sont réalisés par exemple par injection avec des polymères plastiques comme le polypropylène.

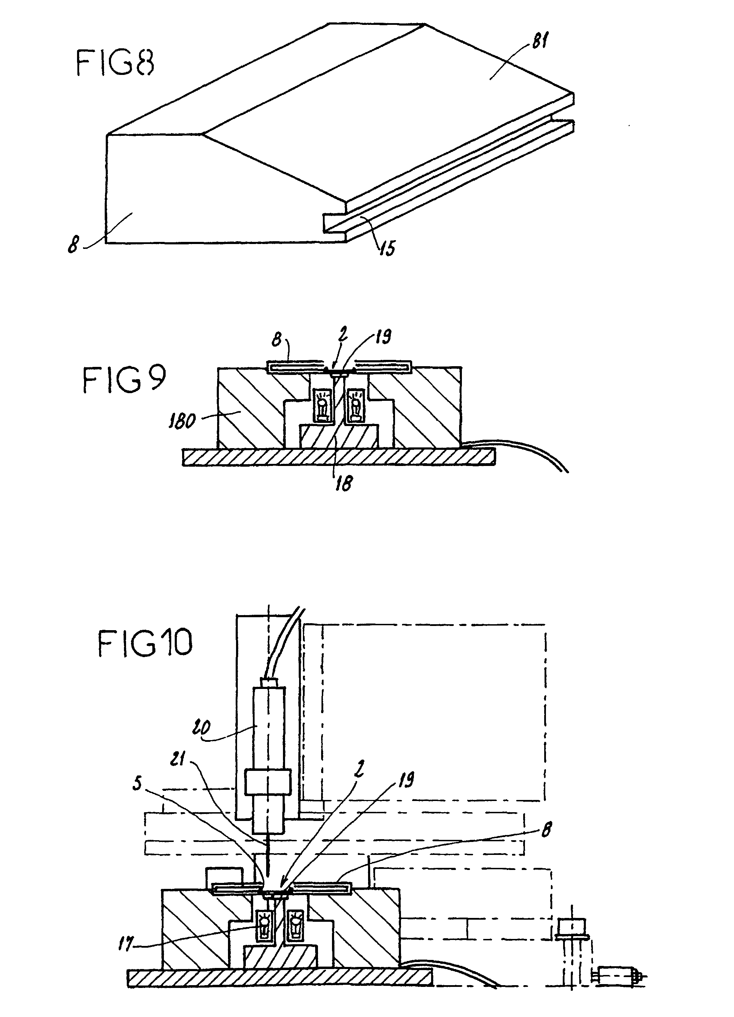

Sur la figure 6, le moyen flexible 12 est une griffe biseautée de section sensiblement triangulaire, la pointe de la griffe venant presser un chant de la biopuce. La partie biseautée a les mêmes avantages que ceux décrits ci-dessus pour les moyens flexibles 12. La figure 7 montre une vue de la jonction contenant/biopuce, mettant en évidence la section triangulaire de cette griffe.

D'autres formes de moyens flexibles 12 existent.

La figure 8 montre une vue en perspective partielle de la fenêtre du contenant 13, dans laquelle une concavité 15, en forme de rainure, est présente dans l'encadrement de la fenêtre 81, pour permettre d'améliorer la fixation de la colle sur le contenant 8. La biopuce, non représentée sur le dessin, est une biopuce carrée, et le dessin représente un coté de la fenêtre 81. Sur le dessin, cette rainure est présente sur la totalité de la portion de fenêtre représentée, mais il est possible de n'avoir cette rainure que sur une partie du pourtour de ladite fenêtre. La forme biseautée de la fenêtre est représentée dans ce mode de réalisation, mais n'est pas nécessaire car la rainure 15 peut éliminer l'excès de colle.

La figure 9 est une représentation schématique de la première étape du procédé de fixation selon un mode de réalisation où le contenant 8 et la biopuce 2 en verre sont mis en place respectivement par les moyens de positionnement 180 et 18. Un cache 19 est situé entre le moyen de positionnement 18 et la biopuce 3.

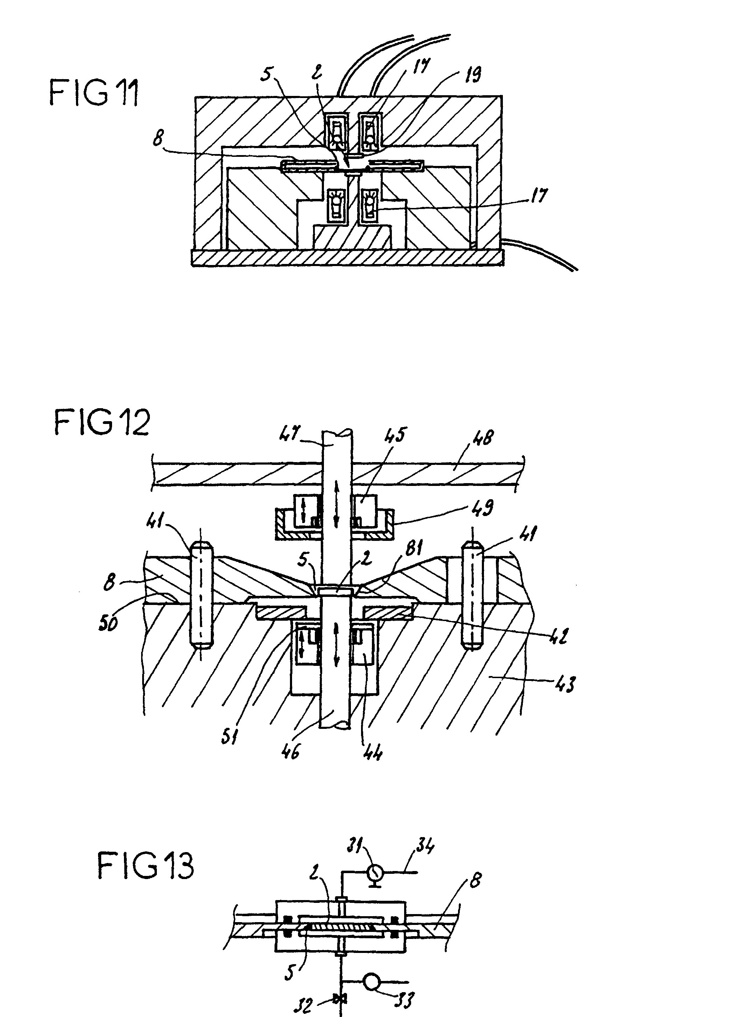

Sur la figure 10, un distributeur de colle 20 muni de son aiguille 21 délivre la quantité de colle sur la totalité du pourtour situé entre la fenêtre 81 du contenant 8 et la bande transversale 7 de la biopuce 2, et une prépolymérisation est effectuée par irradiation UV par l'anneau lumineux 17 situé en dessous de la biopuce.

La figure 11 représente la dernière étape du procédé de fixation, pendant laquelle la polymérisation est terminée par une irradiation UV par le dessus, à l'aide d'un autre anneau lumineux 17, muni lui aussi d'un cache 19 pour protéger la face active de la biopuce.

### Exemple 1 : Attachement d'une biopuce sur un contenant par collage

Un banc d'essais a été réalisé permettant de déposer un joint de colle entre la biopuce 2 et le contenant 8. Ce banc d'essais est représenté schématiquement sur la figure 12.

Une embase inférieure 43 est équipée d'un anneau lumineux 44, réglable manuellement en hauteur, placé autour du support 46 pour la biopuce 2. L'anneau lumineux 44 est protégé par un verre de quartz interchangeable, dans le cas où de la colle coulerait sur l'anneau pendant les essais. La biopuce 2 est maintenue par le vide sur son support 46, également réglable manuellement en hauteur. Cette embase est conçue pour recevoir également un élément consommable ou à usage unique jouant le rôle du contenant 8, dont le positionnement se fait par deux goupilles 41 de référence. Un cache 42 de chaleur interchangeable permet d'illuminer le joint de colle 5 et de protéger la biopuce 2 en fonction de son ouverture. Un bloc supérieur 48 a la forme d'un couvercle amovible. Il est doté d'un anneau lumineux 49 qui permet l'illumination du joint de colle 5 depuis le dessus du contenant 8. L'anneau lumineux 49 est identique à celui 44 de l'embase 43. Un doigt supérieur 47 permet de protéger la surface active de la biopuce, sans contact entre ce doigt et la biopuce 2. Ce doigt est réglable manuellement en hauteur. L'élément 8 est réglable en x, y sur la surface 50, grâce aux goupilles 41 de référence. La lumière UV provient de deux sources lumineuses du type SUPERLITE SUV-DC-P de la société Lumatec, chacune d'une puissance de 200 W. Un dispenseur de colle, comme celui décrit par référence à la figure 10, du type à pression interne, est monté selon l'axe z d'un robot AUTOPLACE 420 de la société Sysmelec (Neuchatel, Suisse), par l'intermédiaire d'une fixation permettant d'incliner l'aiguille. Le robot est piloté par une commande AUTOPLACE de la société Sysmelec, et les paramètres du processus d'assemblage et de collage sont pilotés par un micro-ordinateur. L'aiguille pour pour distribuer la colle est une aiguille en Téflon®. Le dosage de la colle est assuré par le principe pression/temps, c'est-à-dire que l'on applique une pression déterminée, pendant un temps déterminé.

L'élément 8 consommable est réalisé par usinage à partir de matériau plastique en polystyrène, avec une fenêtre 81 variable en taille. La fenêtre du contenant est de section carrée, d'une dimension de 5,717mm ± 0,05 ou 5,577mm ± 0,05 ou 5, 437mm ± 0,05.

La biopuce 2 a pour support un carré de verre d'une dimension de 5,37mm ± 0,18 avec une épaisseur de 0,7mm.

4 colles, notamment à base d'acrylates, par exemple acrylates d'uréthane, ont été testées : les colles Dymax 128M, Dymax 1-20280, Loctite 3104 et Loctite 3105. Les essais réalisés montrent qu'une valeur de 0,8 bar (8 x 10⁴ Pa) comme pression pour le dosage de la colle, permet de bien maîtriser ce dosage. La position de l'aiguille utilisée est verticale, car cette position permet d'avoir une distance minimale entre la pointe de l'aiguille et l'interface biopuce/contenant. La quantité de colle utilisée pour les différentes essais est de quelques mm3 par joint de colle.

Dans un première série d'essais, la colle est prépolymérisée par dessous pendant 10 secondes, puis polymérisée par dessus pendant 20 secondes.

Dans une deuxième série d'essais, la colle est prépolymérisée pendant 5 secondes par dessous, puis polymérisée pendant 20 secondes par dessus.

Dans une troisième série d'essais, la colle est prépolymérisée par dessous pendant 10 secondes, et polymérisée par dessus pendant 2 minutes.

Tous les essais montrent par analyse au microscope que le joint 5 de colle a un très bon aspect visuel, c'est à dire que son contour autour de la biopuce est caractérisé par une géométrie très homogène et qu'il n'y a aucune colle ni sur la surface active de la biopuce, ni sur la face opposée.

Même avec le temps de polymérisation le plus court, qui correspond à la deuxième série d'essais, il est possible de transférer l'ensemble contenant/biopuce sans risque de déplacement de la biopuce.

### Exemple 2 : Test de résistance mécanique et d'étanchéité de l'attachement de la biopuce sur le contenant par collage.

Un banc de test a été conçu pour valider les éléments consommables collés par une mesure de la résistance mécanique et de l'étanchéité. Dans ce banc de test, les éléments consommables sont coincés entre deux plaques formant une cavité de part et d'autre de la biopuce 2. La mesure est effectuée sur le principe de la pression différentielle, ce qui assure une bonne fiabilité de mesure. La cavité de mesure est régulée en température. La banc de test est représenté schématiquement sur la figure 13.

Après avoir introduit un tampon (Carbonate de sodium 25mM, pH 10, vendu par la société Radiometer Analytical Villeurbanne, France, sous la référence S11M007) sur l'une des faces de la biopuce, l'essai consiste à exposer le dispositif à une pression de 900 mbars et à une température de 80°C durant des cycles de 30 minutes. L'absence de variation sur les deux manomètres 31 et 33 est un premier indicateur de la résistance et de l'étanchéité du moyen de fixation 5. Le circuit gazeux comprend une vanne d'entrée 32 et une sortie 34. Un deuxième contrôle visuel peut être effectué en ouvrant le banc de test pour vérifier qu'il n'y a pas de liquide sur l'autre face de la biopuce.

La biopuce 2 a un support 9 ayant la forme d'un carré de verre d'une dimension de 5,37 mm ± 0,18, avec une épaisseur de 0,7 mm.

La fenêtre du contenant est de section carrée d'une dimension de 5,717 mm ± 0,05 ou 5,577mm ± 0,05. Ce contenant est réalisé en polystyrène noir.

La colle utilisée est la colle de la société Dymax 1-20-280 ou de la colle Loctite 3104.

Les conditions choisies sont représentatives de conditions extrêmes pour des réactions entre ligands et analytes puisque, par exemple dans le domaine des immunoessais, la température de réaction est souvent voisines de 37°C. Dans le domaine des acides nucléiques, la température peut varier entre la température ambiante et 95°C, mais les températures de 95°C sont des températures de dénaturation qui sont nécessaires pendant des temps courts, de l'ordre de quelques minutes. Les réactions d'hybridation se produisent généralement entre 30 et 60°C.

Le tableau I ci-dessous résume les résultats obtenus.

**Tableau I**

| Colle (5) | Fenêtre (81) | Nombre d'essais (répétabilité) | Contrôle visuel après 30 minutes | Temps pendant lequel la pression ne varie pas |
|---|---|---|---|---|
| Dymax 1-20-280 | 5,717 mm | 4 | Positif | >230 minutes |
| Dymax 1-20-280 | 5,577 mm | 2 | Positif | > 230 minutes |
| Loctite 3104. | 5,717 mm | 2 | Positif | > 230 minutes |
| Loctite 3104. | 5,577 mm | 4 | Positif | >230 minutes |

Des essais indépendants sont réalisés dans chaque cas de figure pour vérifier la reproductibilité des résultats.

Les essais réalisés avec un tampon à pH 6.0 (phosphate de potassium 100mM, pH6.0) conduisent à des résultats similaires en terme de résistance.

Les essais réalisés avec des températures de 60°C augmentent les temps de résistance.

Dans tous les cas, la résistance mécanique et la résistance à l'étanchéité sont supérieures à 230 minutes, ce qui indique que le moyen de fixation selon l'invention est parfaitement compatible avec les temps de réaction communément utilisés dans des réactions entre ligands et analytes.

L'ensemble des essais réalisés démontre que le moyen de fixation selon l'invention est automatisable, tant du point de vue de la qualité du produit que des conditions de réalisation d'une machine automatique fiable.

## Revendications

1. Dispositif (1) d'analyse d'au moins un analyte, comprenant, d'une part une biopuce (2) comprenant un support (9), par exemple polyédrique, comportant une face active (3) comprenant une surface active (31), sur laquelle sont distribués et attachés une multiplicité de ligands (4) mis en jeu pour l'analyse, au moins une face opposés (6) à la face active (3), et une bande transversale (7) périphérique reliant les faces active (3) et opposée (6), comportant par exemple plusieurs chants (71,74), et d'autre part un contenant (8), ainsi qu'un moyen de fixation (5) disposé de part et d'autre de la face active (3) de la biopuce (2), et reliant, d'un côté la bande transversale (7) de la biopuce, pratiquement à l'exclusion de toute autre partie, face ou surface de ladite biopuce (2), et de l'autre côté le contenant (8), en découvrant la totalité de la zone périphérique (32) de la face active (3) de la biopuce (2), le contenant (8) et la biopuce (2) délimitant un compartiment (10) réactionnel, **caractérise en ce que** la biopuce (2) est en contact avec le contenant (8) uniquement par le moyen de fixation (5), disposé entre, d'un côté la bande transversale (7) de la biopuce, et de l'autre côté le contenant (8).

2. Dispositif (1) d'analyse d'au moins Lin analyte, comprenant d'une part une biopuce (2) comprenant un support (9), par exemple polyédrique, comportant une face active (3) comprenant une surface active (31), sur laquelle sont distribués et attachés une multiplicité de ligands (4) mis en jeu pour l'analyse, au moins une face opposée (6) à la face active (3), et une bande transversale (7) périphérique reliant les faces active (3) et opposée (6), comportant par exemple plusieurs chants (71, 74), et d'autre part un contenant (8) possédant une fenêtre (81), au travers de laquelle ladite biopuce est fixée par un moyen de fixation (5) disposé de part et d'autre de la face active (3) de la biopuce (2), le contenant (8) et la biopuce (2) délimitant un compartiment (10) réactionnel, **caractérisé en ce que** le moyen de fixation (5) de la biopuce (2) relie, d'un côté la bande transversale (7) de la biopuce, pratiquement à l'exclusion de toute autre partie, dont face ou surface de ladite biopuce, et en découvrant la totalité de la zone périphérique (32) de la face active (3) de ladite biopuce, et de l'autre côté l'encadrement de la fenêtre (81) du contenant (8).

3. Dispositif selon la revendication 1, **caractérisé en ce que** l'encadrement de la fenêtre (81) présente une tranche parallèle à la bande transversale (7) de la biopuce.

4. Dispositif d'analyse, selon la revendication 1 ou 2, **caractérisé en ce que** le moyen de fixation découvre complètement la face active (3).

5. Dispositif d'analyse, selon la revendication 4; **caractérisé en ce que** la surface acfive (31) se confond avec la surface de la face activa (3).

6. Dispositif d'analyse selon la revendication 1 ou 2, **caractérisé en ce que** le moyen de fixation (5) est un adhésif.

7. Dispositif d'analyse selon la revendication 2, **caractérisé en ce que** le contenant (8) possède une fenètre (81) ayant un profil transversal sensiblement identique à celui du support (9) de la biopuce (2).

8. Dispositif d'analyse selon la revendication 2, **caractérisé en ce que** la fenêtre (81) du contenant (8) est munie d'un moyen permettant le stockage d'un surplus d'adhésif sans débordement sur la zone périphérique (32) de la biopuce (2).

9. Dispositif selon la revendication 8, **caractérisé en ce que** le moyen de stockage d'un surplus adhésif est constitué par une forme biseautés (14) au niveau de la fenêtre (81) du contenant.

10. Dispositif d'analyse, selon l'une quelconque des revendications 7 à 9, **caractérisé en ce que** l'interstice entire la bordure de la fenêtre (81) et la bande transversale (7) de la biopuce est compris entre 2 mm et 0,05 mm, avantageusement entre 0,5 mm et 0,05 mm et préférentiellement enfre 0,2 mm et 0,1 mm.

11. Dispositif d'analyse, selon l'une quelconque des revendications 1 à 10, **caractérisé en ce que** le moyen de fixation s'étend selon la totalité de la bande transversale (7) de la biopuce.

12. Dispositif d'analyse, selon l'une quelconque des revendications 1 à 11, **caractérisé en ce que** le moyen de fixation (5) relie deux zones opposées de la bande transversale (7), au contenant (8).

13. , Dispositif d'analyse, selon la revendication 6, **caractérisé en ce que** l'adhésif comprend un composant polymérisable par rayonnement ultraviolet.

14. Dispositif d'analyse, selon l'une quelconque des revendications 1 à 13, **caractérisé en ce que** le support (9) de là biopuce (2) est un parallélépipède dont les faces active (3) et opposée (6) sont chacune rectangulaires ou carrées.

15. Dispositif d'analyse, selon l'une quelconque des revendications 1 à 14, **caractérisé en ce que** le compartiment réactionnel (10) est agencé pour mettre en contact un milieu liquide, soumis à l'analyse, et la surface active (31) de la biopuce.

16. Dispositif d'analyse, selon la revendication 15, **caractérisé en ce que** le moyen de fixation (5) assure l'étanchéité du compartiment réactionnel (10) par rapport à l'extérieur.

17. Dispositif d'analyse, selon l'une quelconque des revendications 1 à 16, **caractérisé en ce que** la surface active (31) de la biopuce a une surface inférieure à 100 mm², avantageusement inférieure à 65 mm² et préférentiellement inférieure à 30 mm².

18. Dispositif d'analyse, selon l'une quelconque des revendications 1 à 16, **caractérisé en ce que** la surface active (31) de la biopuce représente au moins 75 % de la surface de la face active (3).

19. Dispositif d'analyse, selon rune quelconque des revendications 1 à 18, **caractérisé en ce que** les ligands sont des acides nucléiques.

20. Dispositif d'analyse, selon la revendication 8, **caractérisé en ce que** le moyen de stockage d'un surplus d'adhésif est constitué par une concavité présente sur tout ou partise du pourtour de la fenêtre (81) du contenant (8), telle qu'une rainure ou un canal.

21. Dispositif d'analyse, selon l'une quelconque des revendications 1 à 20, **caractérisé en ce que** le moyen de fixation (5) comprend des moyens flexibles (12) au niveau de la fenêtre (81) du contenant (8), et exercent une pression sur la bande transversale (7) de la biopuce (2) pour faciliter le positionnement et/ou le maintien en position de ladite biopuce.

22. Dispositif d'analyse, selon la revendication 21, **caractérisé en ce que** les moyens flexibles (12) sont constituées de deux parties solidaires entre elles, à savoir une partie intermédiaire inclinée par rapport à la face opposée (6) de la biopuce, et une partie terminale sensiblement perpendiculaire à ladite face opposée, ladite partie terminale exerçant une pression sur la bande transversale (7) de la biopuce.

23. Disposer d'analyse, selon la revendication 21, **caractérisé en ce que** les moyens flexibles (12) comprennent des griffes de section sensiblement triangulaire.

24. Procédé de fixation d'une biopuce à un contenant pour réaliser un dispositif d'analyse selon l'une quelconque des revendications 1 à 23, **caractérisé en ce que** l'on maintient la biopuce (2) en regard du contenant (8), que l'on répartit un joint d'adhésif liquide entre la bande transversale (7) de la biopuce et le contenant (8), et que l'on polymérise l'adhésif (5) par rayonnement ultraviolet.

25. Procédé de fixation, selon la revendication 24, **caractérisé en ce que** l'on positionne la biopuce (2) par rapport au contenant (8), pour mettre en regard la bande transversale (7) de la biopuce et l'encadrement de la fenêtre (81) du contenant (8).

26. Procédé de fixation, selon la revendication 25, **caractérisé en ce que** le maintien de la biopuce (2) et/ou du contenant (8) sur le ou les moyens de positionnement est assuré par l'application d'une dépression.

27. Procédé de fixation, selon l'une quelconque des revendications 24 à 26, **caractérisé en ce qu'**un rayonnement ultraviolet est appliqué au niveau du joint d'adhésif sur au moins une des faces du dispositif d'analyse.

28. Procédé de fixation, selon l'une quelconque des revendications 24 à 27, **caractérisé en ce que** l'on positionne un cache entre la biopuce et la rayonnement ultraviolet pour protéger les ligands dans la surface active (31).

## Patentansprüche

1. Vorrichtung (1) zur Analyse von zumindest einem Analyten, die einerseits einen Biochip (2) aufweist, der einen beispielsweise polyedrischen Träger (9) aufweist, der eine aktive Fläche (3) umfasst, die eine aktive Oberfläche (31) aufweist, auf der eine Vielzahl von Liganden (4) verteilt und angebracht sind, die zur Analyse eingesetzt werden, und der zumindest eine der aktiven Fläche (3) gegenüberliegende Fläche (6) sowie einen umfänglichen seitlichen Rand (7) umfasst, der die aktive (3) und die dieser gegenüberliegende Fläche (6) miteinander verbindet, und der beispielsweise mehrere Schmalseiten (71, 74) umfasst, wobei die Vorrichtung andererseits ein Behältnis (8) sowie ein Fixierungsungsmittel (5) aufweist, das beiderseits der aktiven Fläche (3) des Biochips (2) angeordnet ist, und das einerseits mit dem seitlichen Rand (7) des Biochips praktisch unter Ausschluss jeglichen anderen Teils, jeglicher anderen Fläche oder anderen Oberfläche des Biochips (2), und andererseits mit dem Behältnis (8) verbunden ist, wobei der gesamte periphere Bereich (32) der aktiven Fläche (3) des Biochips (2) unbedeckt gelassen wird, und das Behältnis (8) und der Biochip (2) ein Reaktionskompartiment (10) begrenzen, **dadurch gekennzeichnet, dass** der Biochip (2) mit dem Behältnis (8) ausschließlich über das Fixierungsmittel (5) in Kontakt steht, das zwischen einerseits dem seitlichen Rand (7) des Biochips und andererseits dem Behältnis (8) angeordnet ist.

2. Vorrichtung (1) zur Analyse von zumindest einem Analyten, die einerseits einen Biochip (2) aufweist, der einen beispielsweise polyedrischen Träger (9) aufweist, der eine aktive Fläche (3) umfasst, die eine aktive Oberfläche (31) aufweist, auf der eine Vielzahl von Liganden (4) verteilt und angebracht sind, die zur Analyse eingesetzt werden, und der zumindest eine der aktiven Fläche (3) gegenüberliegende Fläche (6) sowie einen umfänglichen seitlichen Rand (7) umfasst, der die aktive (3) und die dieser gegenüberliegende Fläche (6) miteinander verbindet, und der beispielsweise mehrere Schmalseiten (71, 74) umfasst, wobei die Vorrichtung andererseits ein Behältnis (8) mit einem Fenster (81) aufweist, in dem der Bio-Chip über ein Fixierungsmittel (5) fixiert ist, das beiderseits der aktiven Fläche (3) des Biochips (2) angeordnet ist, wobei das Behältnis (8) und der Biochip (2) ein Reaktionskompartiment (10) begrenzen, **dadurch gekennzeichnet, dass** das Fixierungsmittel (5) des Biochips (2) einerseits mit dem seitlichen Rand (7) des Biochips praktisch unter Ausschluss jeglichen anderen Teils, darunter die Fläche oder Oberfläche des Biochips, und andererseits mit dem Rahmens des Fensters (81) des Behältnisses (8) verbunden ist, und dabei den gesamten peripheren Bereich (32) der aktiven Fläche (3) des Biochips unbedeckt lässt.

3. Vorrichtung nach Anspruch 1, **dadurch gekennzeichnet, dass** der Rahmen des Fensters (81) ein zu dem seitlichen Rand (7) des Biochips paralleles Teil aufweist.

4. Analysevorrichtung nach Anspruch 1 oder 2, **dadurch gekennzeichnet, dass** das Fixierungsmittel die aktive Fläche (3) vollständig unbedeckt lässt.

5. Analysevorrichtung nach Anspruch 4, **dadurch gekennzeichnet, dass** die aktive Oberfläche (31) mit der Oberfläche der aktiven Fläche (3) verschmolzen ist.

6. Analysevorrichtung nach Anspruch 1 oder 2, **dadurch gekennzeichnet, dass** das Fixierungsmittel (5) ein Klebemittel ist.

7. Analysevorrichtung nach Anspruch 2, **dadurch gekennzeichnet, dass** das Behältnis (8) ein Fenster (81) mit einem Querprofil aufweist, das im Wesentlichen zu dem des Trägers (9) des Biochips (2) identisch ist.

8. Analysevorrichtung nach Anspruch 2, **dadurch gekennzeichnet, dass** das Fenster (81) des Behältnisses (8) mit einem Mittel versehen ist, das die Aufnahme eines Klebemittelüberschusses ohne Übertreten auf den peripheren Bereich (32) des Biochips (2) ermöglicht.

9. Vorrichtung nach Anspruch 8, **dadurch gekennzeichnet, dass** das Mittel zur Aufnahme eines Klebemittelüberschusses durch eine im Bereich des Fensters (81) des Behältnisses abgeschrägte Form (14) gebildet ist.

10. Analysevorrichtung nach einem der Ansprüche 7 bis 9, **dadurch gekennzeichnet, dass** der Zwischenraum zwischen dem Rand des Fensters (81) und dem seitlichen Rand (7) des Biochips bei 2 mm bis 0,05 mm, vorzugsweise bei 0,5 mm bis 0,05 mm und bevorzugt bei 0,2 mm bis 0,1 mm liegt.

11. Analysevorrichtung nach einem der Ansprüche 1 bis 10, **dadurch gekennzeichnet, dass** sich das Fixierungsmittel entlang des gesamten seitlichen Rands (7) des Biochips erstreckt.

12. Analysevorrichtung nach einem der Ansprüche 1 bis 11, **dadurch gekennzeichnet, dass** das Fixierungsmittel (5) beide sich gegenüberliegenden Bereiche des seitlichen Rands (7) mit dem Behältnis (8) verbindet.

13. Analysevorrichtung nach Anspruch 6, **dadurch gekennzeichnet, dass** das Klebemittel eine mittels ultravioletter Strahlung polymerisierbare Komponente aufweist.

14. Analysevorrichtung nach einem der Ansprüche 1 bis 13, **dadurch gekennzeichnet, dass** der Träger (9) des Biochips (2) ein Parallelepiped ist, wobei dessen aktive (3) und die dieser gegenüberliegende Fläche (6) jeweils rechteckig oder viereckig sind.

15. Analysevorrichtung nach einem der Ansprüche 1 bis 14, **dadurch gekennzeichnet, dass** das Reaktionskompartiment (10) dazu eingerichtet ist, ein zu analysierendes flüssiges Medium mit der aktiven Oberfläche (31) des Biochips in Kontakt zu bringen.

16. Analysevorrichtung nach Anspruch 15, **dadurch gekennzeichnet, dass** das Fixierungsmittel (5) die Dichtigkeit des Reaktionskompartiments (10) nach außen gewährleistet.

17. Analysevorrichtung nach einem der Ansprüche 1 bis 16, **dadurch gekennzeichnet, dass** die aktive Oberfläche (31) des Biochips eine Oberfläche aufweist, die kleiner als 100 mm², vorzugsweise kleiner als 65 mm² und bevorzugt kleiner als 30 mm² ist.

18. Analysevorrichtung nach einem der Ansprüche 1 bis 16, **dadurch gekennzeichnet, dass** die aktive Oberfläche (31) des Biochips zumindest 75 % der Oberfläche der aktiven Fläche (3) entspricht.

19. Analysevorrichtung nach einem der Ansprüche 1 bis 18, **dadurch gekennzeichnet, dass** die Liganden Nukleinsäuren sind.

20. Analysevorrichtung nach Anspruch 8, **dadurch gekennzeichnet, dass** das Mittel zur Aufnahme eines Klebemittelüberschusses durch eine Einbuchtung gebildet ist, die auf dem gesamten Umfang des Fensters (81) des Behältnisses (8) oder auf Teilen hiervon, bspw. als Rille oder Kanal, vorhanden ist.

21. Analysevorrichtung nach einem der Ansprüche 1 bis 20, **dadurch gekennzeichnet, dass** das Fixierungsmittel (5) im Bereich des Fensters (81) des Behältnisses (8) flexible Mittel (12) aufweist und auf den seitlichen Rand (7) des Biochips (2) Druck ausübt, um die Positionierung und/oder das In-Position-Halten des Biochips zu erleichtern.

22. Analysevorrichtung nach Anspruch 21, **dadurch gekennzeichnet, dass** die flexiblen Mittel (12) aus zwei miteinander verbundenen Teilen bestehen, nämlich aus einem Zwischenteil, das in Bezug auf die gegenüberliegende Fläche (6) des Biochips geneigt ist, und aus einem Abschlussteil, das im Wesentlichen senkrecht zu dieser gegenüberliegenden Fläche ist, wobei das Abschlussteil auf den seitlichen Rand (7) des Biochips Druck ausübt.

23. Analysevorrichtung nach Anspruch 21, **dadurch gekennzeichnet, dass** die flexiblen Mittel (12) Aufnehmevorrichtungen von im Wesentlichen dreieckigem Querschnitt aufweisen.

24. Verfahren zur Fixierung eines Biochips an ein Behältnis, um eine Analysevorrichtung nach einem der Ansprüche 1 bis 23 herzustellen, **dadurch gekennzeichnet, dass** der Biochip (2) gegenüber dem Behältnis (8) in Position gehalten wird, dass zwischen dem seitlichen Rand (7) des Biochips und dem Behältnis (8) eine Dichtung aus flüssigem Klebemittel verteilt wird, und dass das Klebemittel (5) mittels ultravioletter Strahlung polymerisiert wird.

25. Fixierungsverfahren nach Anspruch 24, **dadurch gekennzeichnet, dass** der Biochip (2) im Hinblick auf das Behältnis (8) so positioniert wird, dass sich der seitliche Rand (7) des Biochips und der Rahmen des Fensters (81) des Behältnisses (8) gegenüberliegen.

26. Fixierungsverfahren nach Anspruch 25, **dadurch gekennzeichnet, dass** das In-Position-Halten des Biochips (2) und/oder des Behältnisses (8) auf dem Positionierungsmittel oder den Positionierungsmitteln durch Anlegen eines Unterdrucks gewährleistet wird.

27. Fixierungsverfahren nach einem der Ansprüche 24 bis 26, **dadurch gekennzeichnet, dass** im Bereich der Klebemitteldichtung auf zumindest einer der Seiten der Analysevorrichtung ultraviolette Strahlung angelegt wird.

28. Fixierungsverfahren nach einem der Ansprüche 24 bis 27, **dadurch gekennzeichnet, dass** zwischen dem Biochip und der ultravioletten Strahlung eine Maske positioniert wird, um die Liganden an der aktiven Oberfläche (31) zu schützen.

## Claims

1. Device (1) for analysing at least one analyte, comprising, firstly, a biochip (2) comprising a support (9), for example a polyhedral support, comprising an active face (3) comprising an active surface (31), onto which are distributed and attached a plurality of ligands (4) used for the analysis, at least one face (6) opposite the active face (3), and a transverse peripheral strip (7) connecting the active (3) and opposite (6) faces, comprising, for example, several sides (71, 74), and, secondly, a container (8), and also an attachment means (5) placed on both sides of the active face (3) of the biochip (2), and connecting, on one side, the transverse strip (7) of the biochip, virtually excluding any other part, face or surface of said biochip (2) and, on the other side, the container (8), completely exposing the peripheral zone (32) of the active face (3) of the biochip (2), the container (8) and the biochip (2) delimiting a reaction compartment (10), **characterized in that** the biochip (2) is in contact with the container (8) only via the attachment means (5), placed between, on one side, the transverse strip (7) of the biochip and, on the other side, the container (8).

2. Device (1) for analysing at least one analyte, comprising, firstly, a biochip (2) comprising a support (9), for example a polyhedral support, comprising an active face (3) comprising an active surface (31), onto which are distributed and attached a plurality of ligands (4) used for the analysis, at least one face (6) opposite the active face (3), and a transverse peripheral strip (7) connecting the active (3) and opposite (6) faces, comprising, for example, several sides (71, 74), and, secondly, a container (8) which has a window (81), through which said biochip is attached via an attachment means (5) placed on both sides of the active face (3) of the biochip (2), the container (8) and the biochip (2) delimiting a reaction compartment (10), **characterized in that** the attachment means (5) of the biochip (2) connects, on one side, the transverse strip (7) of the biochip, virtually excluding any other part, including face or surface, of said biochip, completely exposing the peripheral zone (32) of the active face (3) of said biochip and, on the other side, the frame of the window (81) of the container (8).

3. Device according to Claim 1, **characterized in that** the frame of the window (81) has an edge parallel to the transverse strip (7) of the biochip.

4. Analytical device according to Claim 1 or 2, **characterized in that** the attachment means completely exposes the active face (3).

5. Analytical device according to Claim 4, **characterized in that** the active surface (31) merges with the surface of the active face (3).

6. Analytical device according to Claim 1 or 2, **characterized in that** the attachment means (5) is an adhesive.

7. Analytical device according to Claim 2, **characterized in that** the container (8) has a window (81) with a transverse profile substantially identical to that of the support (9) of the biochip (2).

8. Analytical device according to Claim 2, **characterized in that** the window (81) of the container (8) is equipped with a means which allows a surplus of adhesive to be stored without it overflowing onto the peripheral zone (32) of the biochip (2).

9. Device according to Claim 8, **characterized in that** the means for storing a surplus of adhesive consists of a bevelled shape (14) at the level of the window (81) of the container.

10. Analytical device according to any one of Claims 7 to 9, **characterized in that** the interstice between the border of the window (81) and the transverse strip (7) of the biochip is between 2 mm and 0.05 mm, advantageously between 0.5 mm and 0.05 mm, and preferentially between 0.2 mm and 0.1 mm.

11. Analytical device according to any one of Claims 1 to 10, **characterized in that** the attachment means extends along the entire transverse strip (7) of the biochip.

12. Analytical device according to any one of Claims 1 to 11, **characterized in that** the attachment means (5) connects two opposite zones of the transverse strip (7), to the container (8).

13. Analytical device according to Claim 6, **characterized in that** the adhesive comprises a component which can be cured by ultraviolet radiation.

14. Analytical device according to any one of Claims 1 to 13, **characterized in that** the support (9) of the biochip (2) is a parallelepiped, the active (3) and opposite (6) faces of which are each rectangular or square.

15. Analytical device according to any one of Claims 1 to 14, **characterized in that** the reaction compartment (10) is arranged so as to bring a liquid medium, subjected to the analysis, and the active surface (31) of the biochip into contact.

16. Analytical device according to Claim 15, **characterized in that** the attachment means (5) ensures that the reaction compartment (10) is leaktight with respect to the outside.

17. Analytical device according to any one of Claims 1 to 16, **characterized in that** the active surface (31) of the biochip has a surface area of less than 100 mm², advantageously less than 65 mm², and preferentially less than 30 mm².

18. Analytical device according to any one of Claims 1 to 16, **characterized in that** the active surface (31) of the biochip represents at least 75% of the surface area of the active face (3).

19. Analytical device according to any one of Claims 1 to 18, **characterized in that** the ligands are nucleic acids.

20. Analytical device according to Claim 8, **characterized in that** the means for storing a surplus of adhesive consists of a concavity present on all or part of the surround of the window (81) of the container (8), such as a groove or a channel.

21. Analytical device according to any one of Claims 1 to 20, **characterized in that** the attachment means (5) comprises means which are flexible (12) at the level of the window (81) of the container (8), and exert a pressure on the transverse strip (7) of the biochip (2) so as to facilitate the positioning and/or the maintaining in position of said biochip.

22. Analytical device according to Claim 21, **characterized in that** the flexible means (12) consist of two interdependent components, namely an intermediate component inclined relative to the opposite face (6) of the biochip, and an end component substantially perpendicular to said opposite face, said end component exerting a pressure on the transverse strip (7) of the biochip.

23. Analytical device according to Claim 21, **characterized in that** the flexible means (12) comprise claws, the cross section of which is substantially triangular.

24. Process for attaching a biochip to a container, for producing an analytical device according to any one of Claims 1 to 23, **characterized in that** the biochip (2) is maintained opposite the container (8), **in that** a liquid adhesive seal is distributed between the transverse strip (7) of the biochip and the container (8), and **in that** the adhesive (5) is cured by ultraviolet radiation.

25. Attachment process according to Claim 24, **characterized in that** the biochip (2) is positioned relative to the container (8) so as to place the transverse strip (7) of the biochip opposite the frame of the window (81) of the container (8).

26. Attachment process according to Claim 25, **characterized in that** the biochip (2) and/or the container (8) is (are) maintained on the positioning means by applying a vacuum.

27. Attachment process according to any one of Claims 24 to 26, **characterized in that** ultraviolet radiation is applied to the adhesive seal on at least one of the faces of the analytical device.

28. Attachment process according to any one of Claims 24 to 27, **characterized in that** a mask is positioned between the biochip and the ultraviolet radiation in order to protect the ligands in the active surface (31).
